# EUROPEAN PATENT SPECIFICATION

(11) **EP 3 163 984 B1**
(45) Date of publication and mention of the grant of the patent: **08.08.2018**
(21) Application number: 16195933.3
(22) Date of filing: 27.10.2016
(51) Int. Cl.: H05K 1/11, C25D 5/50, H05K 3/34

(54) **PRE-TIN SHAPING SYSTEM AND METHOD**
VORVERZINNUNGSFORMUNGSSYSTEM UND VERFAHREN
SYSTÈME ET PROCÉDÉ DE FAÇONNAGE DE PRÉ-ÉTAMAGE

(30) Priority: 27.10.2015 CN 201510713062
(43) Date of publication of application: 03.05.2017
(73) Proprietor: Tyco Electronics (Dongguan) Ltd., Dongguan, Guangdong 523958 (CN); Tyco Electronics (Shanghai) Co., Ltd., Pilot Free Trade Zone Shanghai (CN); Shenzhen AMI Technology Co. Ltd, Shenzhen Guangdong 518108 (CN); TE Connectivity Germany GmbH, 64625 Bensheim (DE)
(72) Inventor: SHEN, Hongzhou, Shanghai, Shanghai (CN); ZHANG, Dandan, Shanghai, Shanghai (CN); ZENG, Qinglong, Shanghai, Shanghai (CN); LU, Roberto Francisco-Yi, Berwyn, PA Pennsylvania 19312 (US); DUBNICZKI, George, Shanghai, Shanghai (CN)
(74) Representative: Grünecker Patent- und Rechtsanwälte PartG mbB

(56) References cited:
- US-A- 4 997 122
- US-A- 5 943 217
- US-A1- 2003 038 163
- US-A1- 2007 145 101

## Description

### CROSS-REFERENCE TO RELATED APPLICATION

This application claims the benefit of Chinese Patent Application No. 201510713062.1 filed on Oct. 27, 2015 in the State Intellectual Property Office of China, the whole disclosure of which is incorporated herein by reference.

### BACKGROUND

### Technical Field

The present disclosure relates to a technical field of electrical connector, and more particularly, it relates to a system and a method for shaping a pre-tin in a pad of a circuit board.

### Description of the Related Art

In the technical field of electrical connector, a circuit board having tin-plated pads is a basic component, wherein the tin-plated pads are formed on the surface of the circuit board by SMT (surface mount technology), and electrical contacts of an electrical connector are welded onto the tin-plated pads of the circuit board by a welding technology, such as cold soldering and the like, in order to obtain structural and electrical connection with the electrical connector. However, in practice, the problem of electrical connection failure, which is caused by dry joint or faulty joint between the electrical contact and the tin pad and the like, arises frequently. Documents US 4 997 122 A, US 2007/145101 A1 and US 5 943 217 A show structuring of the pads by stamping in order to avoid faulty joints.

### SUMMARY

The present disclosure aims to solve at least one aspect of the above mentioned technical problems or other technical problems existing in the prior art.

Thus, one object of the present disclosure is to provide a pre-tin shaping system, which is able to precisely control a position of an electrical contact on a pad of a circuit board during soldering by performing a shaping operation to a pre-tin on the pad of the circuit board, thereby guaranteeing soldering quality, and reducing a risk of dry joint or faulty joint and the like.

Another object of the present disclosure is to provide a pre-tin shaping method, which is able to precisely control a position of the electrical contact on the pad of the circuit board during soldering by performing the shaping operation to the pre-tin on the pad of the circuit board, thereby guaranteeing soldering quality, and reducing a risk of dry joint or faulty joint and the like.

According to one aspect of the present disclosure, there is provided a pre-tin shaping system for shaping a pre-tin on a pad of a circuit board, wherein the pre-tin shaping system comprises:
a board holding unit for securely holding the circuit board;
a heat-press unit for performing a heat-press operation to the pre-tin on the pad of the circuit board so as to shape the pre-tin; and
a motion unit for moving the heat-press unit relative to the board holding unit;
wherein the heat-press unit comprises a heat presser for shaping the pre-tin on the pad of the circuit board, and wherein, the heat presser comprises two supporting portions and a heat pressing portion disposed between the two supporting portions, wherein, when the heat presser performs the heat-press operation to the pre-tin on the pad of the circuit board, the pre-tin is pressed by the heat pressing portion while the supporting portions come into contact with the circuit board at each side of the pad so as to inhibit molten pre-tin from flowing towards adjacent pads.

In some embodiments, the heat pressing portion has a U-shaped or V-shaped cross-section.

In some embodiments, the heat pressing portion is made of a material that is not adhesive to the pre-tin. In some embodiments, the material that is not adhesive to the pre-tin comprises molybdenum alloy or titanium alloy.

In some embodiments, the heat-press unit comprises one or more heat pressers.

In some other embodiments, the board holding unit is moveable relative to the motion unit.

In some embodiments, the system further comprises a temperature control unit provided at the heat-press unit and configured to control a temperature at which the heat-press operation is performed by the heat-press unit.

In another aspect of the present disclosure, there is provided a method for shaping the pre-tin by the pre-tin shaping system above-mentioned, the method comprising the following steps:
securely holding the circuit board by the board holding unit;
moving the heat-press unit relative to the board holding unit by the motion unit so as to align the heat presser of the heat-press unit to the pre-tin on the pad of the circuit board; and
performing the heat-press operation to the pre-tin on the pad of the circuit board by the heat-press unit so as to shape the pre-tin, wherein the heat presser comprises two supporting portions and a heat pressing portion between the two supporting portions, and the method further comprises the following step:
when the heat presser performs the heat-press operation to the pre-tin on the circuit board, the pre-tin is pressed by the heat pressing portion while the supporting portions come into contact with the circuit board at each side of the pad so as to inhibit molten pre-tin from flowing towards adjacent pads.

In some embodiments, the method further comprises the following step: moving the board holding unit relative to the motion unit.

In some other embodiments, the heat-press unit comprises one or more heat pressers, and the method further comprises the following step: performing the heat-press operation simultaneously by the one or more heat pressers.

In some embodiments, the system further comprises a temperature control unit provided at the heat-press unit, and the method further comprises the following step: adjusting, by the temperature control unit, by means of a close-loop feedback control, the temperature at which the heat-press operation is performed by the heat-press unit.

The present disclosure achieves at least the following technical effects.

With the pre-tin shaping system and method provided herein, the heat-press operation to the pre-tin on the pad of the circuit board that is securely held in the board holding unit is performed by the heat presser so that the pre-tin on the pad is pressed into a predetermined shape (for example the shaped pre-tin has a V-shaped or U-shaped cross-section or any other suitable cross-section shape), thereby facilitating a soldering connection, performed in a subsequent process, between an electrical contact (not shown) and the pre-tin on the pad of the circuit board. It can be seen that, with the pre-tin shaping system and method provided herein, by performing a shaping operation to the pre-tin on the pad of the circuit board, position of an electrical contact on the pad of the circuit board during soldering will be precisely controlled, thereby guaranteeing soldering quality and reducing a risk of dry joint or faulty joint and the like.

The above and other objects and other technical effects of the present disclosure will be described in the following exemplary embodiments thereof accompanying with the accompanying drawings.

### BRIEF DESCRIPTION OF THE DRAWINGS

In order to make the above and other object, technical features and technical effects of the present disclosure more apparent, the present disclosure will be further described in combination with the exemplary embodiments and the accompanying drawings.
Figs.1 is a schematic structure view of a pre-tin shaping system according to a specific embodiment of the present disclosure;
Fig.2 is a schematic structure view of a circuit board together with a pre-tin on a pad thereof, before performing a heat-press operation by using the pre-tin shaping system according to a specific embodiment of the present disclosure;
Fig.3 is a schematic structure view of the circuit board together with the pre-tin on the pad thereof, after performing the heat-press operation by using the pre-tin shaping system according to a specific embodiment of the present disclosure;
Fig.4 is a schematic partial structure view of a heat presser in the pre-tin shaping system according to a specific embodiment of the present disclosure, when the heat presser is performing the heat-press operation on the circuit board; and
Fig.5 is a partially enlarged schematic view of a portion of Fig.4.

### DETAILED DESCRIPTION OF EMBODIMENTS

The specific embodiments of the present disclosure will be described hereinafter in detail, and examples thereof are illustrated in the attached drawings, in which the like reference numerals refer to the like elements. The specific embodiments described with reference to the attached drawings are only exemplary so as to explain the present disclosure, and should not be construed as a limitation to the present disclosure.

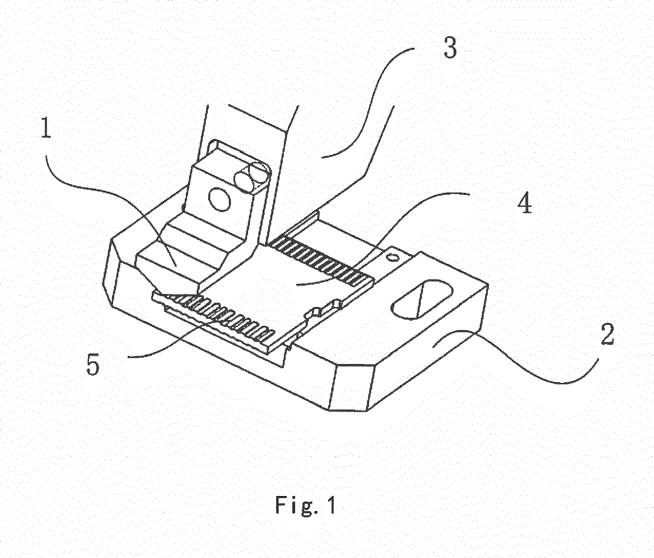

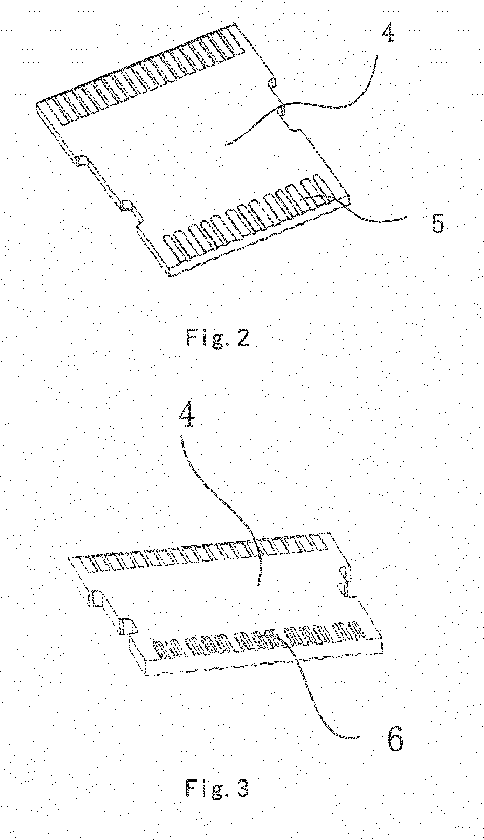

With reference to Fig.1, Fig. 1 shows a schematic structure view of a pre-tin shaping system according to a specific embodiment of the present disclosure. As shown, the present disclosure provides a pre-tin shaping system for shaping a pre-tin 5 on a pad of a circuit board 4. The pre-tin shaping system mainly comprises: a heat-press unit 1, a board holding unit 2 and a motion unit 3; wherein the board holding unit 2 is adapted to securely hold the circuit board 4; the heat-press unit 1 is adapted to perform a heat-press operation to the pre-tin 5 on the circuit board 4 so as to shape the pre-tin, wherein the heat-press unit 1 includes a heat presser 10 for shaping the pre-tin on the circuit board; while the motion unit 3 is adapted to move the heat-press unit 1 relative to the board holding unit 2 to determine a relative position between the heat presser 10 of the heat-press unit 1 and the circuit board 4 securely held by the board holding unit 2, thereby contributing to perform the heat-press operation to the pre-tin 5 on the pad of the circuit board 4 by the heat presser 10. According to the pre-tin shaping system provided by the present disclosure, the heat-press operation to the pre-tin 5 on the pad of the circuit board 4 is performed by the heat presser 10 so that the pre-tin 5 on the pad is pressed into a predetermined shape (for example, in the embodiment as shown in Fig.3, the shaped pre-tin 6 has a V-shaped cross-section), thereby facilitating a soldering connection, performed in a subsequent process, between the electrical contact (not shown) and the pre-tin 5 on the pad of the circuit board 4. For example, Fig.2 shows a schematic structure view of the circuit board together with the pre-tin on the pad thereof, before performing the heat-press operation by using the pre-tin shaping system according to a specific embodiment of the present disclosure; and Fig.3 is a schematic structure view of the circuit board together with the pre-tin on the pad thereof, after performing the heat-press operation by the abovementioned pre-tin shaping system. Before performing the heat-press operation by using the pre-tin shaping system provided by the present disclosure, the pre-tin 5 on the pad of the circuit board 4 has a flat surface (as shown in Fig.2), which is adverse to the soldering connection with the electrical contact. However, when the heat-press operation is performed by using the pre-tin shaping system provided by the present disclosure, the shaped pre-tin 6 on the pad of the circuit board 4 has a V-shaped cross-section (as shown in Fig.3), which is advantageous to precisely control a position of the electrical contact in the pad of the circuit board 4 and in turn is advantageous to the soldering connection.

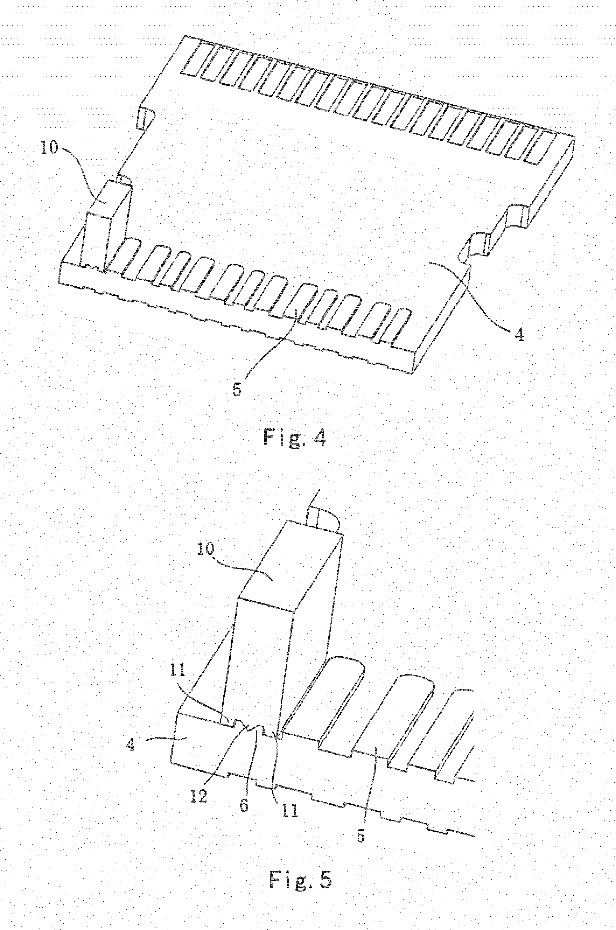

Fig.4 shows a schematic partial structure view of a heat presser included in the pre-tin shaping system according to a specific embodiment of the present disclosure, when the heat presser is performing the heat-press operation on the circuit board, and Fig. 5 is an partially enlarged view of Fig.4. As illustrated in Figs. 1, 4-5, one end of the heat presser 10 is connected to the motion unit 3, and the other end thereof comprises two supporting portions 11 and a heat pressing portion 12 disposed between the two supporting portions 11 (see Figs. 4 and 5). The heat pressing portion 12 may have a particular section shape as required, such as V shape (see Fig.5) or U shape, or any other suitable shape. When the system provided herein is in use, particularly when the heat-press operation to the pre-tin 5 on the pad of the circuit board 4 is performed by the heat presser 10, the pre-tin 5 on the pad of the circuit board 4 is pressed by the heat presser 10, here, the pre-tin 5 to be shaped is melted by the heat pressing portion 12 at a temperature with which the pre-tin will be molten, and then is shaped into a section shape corresponding to the section shape (such as the V shape as shown in Fig.5) of the heat pressing portion 12 of the heat presser 10. Meanwhile, the supporting portions 11 at each side of the heat pressing portion 12 come into contact with a base of the circuit board at each side of the pad of the circuit board 4 so as to inhibit molten pre-tin 5 from flowing towards adjacent pads.

According to the present disclosure, the heat presser 10 is made of material that is not adhesive to the pre-tin. Preferably, at least the supporting portions 11 and the heat pressing portion 12 of the heat presser 10 are made of material that is not adhesive to the pre-tin. For example, the material that is not adhesive to the pre-tin comprises, but is not limited to, molybdenum alloy or titanium alloy.

According to the present disclosure, the heat-press unit 1 may comprise one or more heat pressers 10. In some embodiments, such as the embodiment as shown in Figs. 1, 4-5, the heat-press unit 1 comprises one heat presser 10. In this case, when the system provided herein is in use, the heat presser 10 in the heat-press unit 1 is moved by the motion unit 3 so as to perform the heat-press operation to the pre-tins 5 on the pads of the circuit board 4 one by one, and shape the pre-tins 5 on the pads of the circuit board 4 one by one. However, in some other embodiments, the heat-press unit 1 may also comprise a plurality of heat pressers 10 arranged in parallel so as to simultaneously perform the heat-press operation to the pre-tins 5 on the pads of the circuit board 4. Regarding to the specific number of the heat presser 10, it may be designed as required.

Further, in the pre-tin shaping system provided by the present disclosure, the system may further comprise a temperature control unit (not shown) configured to control a temperature at which the heat-press operation is performed by the heat-press unit 1.For example, by means of close-loop feedback control, the temperature control unit may heat the heat presser in the heat-press unit to different predetermined temperatures under which the pre-tin is melted according to different compositions of the pre-tin.

In some embodiments, the temperature control unit may be provided at the heat-press unit. In some other embodiments, the temperature control unit may be provided separately. As for the temperature control unit, common temperature control device and technology in this art may be adopted.

Additionally, in the pre-tin shaping system provided by the present disclosure, the motion unit 3 may be a motion system of any form, that's to say, it may be a two dimensional motion system, and also may be a three dimensional motion system, as long as it can meet the requirement of movement accuracy of moving the heat presser in the heat-press unit relative to the circuit board securely held in the board holding unit. For example, the motion unit 3 may be a 4-aixs or a 6-aixs motion robot (arm) and the like.

Additionally, in the pre-tin shaping system provided by the present disclosure, the board holding unit 2 is adapted to securely hold the circuit board 4. For example, it may be a PCB fixer and the like. Moreover, the board holding unit 2 may be fixed relative to the motion unit 3, and also may be moveable relative to the motion unit 3. For example, in the illustrated embodiment, the board holding unit 2 is fixed relative to the motion unit 3. However, in the case that the board holding unit 2 is moveable relative to the motion unit 3, the movement accuracy of the relative movement between the board holding unit 2 and the motion unit 3 should be guaranteed.

At the same time, the present disclosure also provides a method for shaping the pre-tin by the abovementioned pre-tin shaping system. The pre-tin shaping method comprises the steps of: securely holding the circuit board 4 by the board holding unit 2; moving the heat-press unit 1 relative to the board holding unit 2 by the motion unit 3 so as to align the heat presser 10 of the heat-press unit 1 to the pre-tin 5 on the pad of the circuit board 4; and performing the heat-press operation to the pre-tin 5 on the pad of the circuit board 4 by the heat-press unit 1 so as to shape the pre-tin 5.

To be specific, the heat presser comprises two supporting portions 11 and a heat pressing portion 12 disposed between the two supporting portions 11. The pre-tin shaping method further comprises the step of: when the heat presser 10 performs the heat-press operation to the pre-tin 5 on the circuit board 4, pressing, by the heat presser 10, the pre-tin 5 on the pad of the circuit board 4 , wherein, the pre-tin 5 to be shaped is melted by the heat pressing portion 12 at a temperature under which the pre-tin is melted, and then is shaped into a section shape corresponding to the section shape (such as the V shape as shown in Fig.5) of the heat pressing portion 12 of the heat presser 10, meanwhile, the supporting portions 11 at each side of the heat pressing portion 12 come into contact with a base of the circuit board at each side of the pad of the circuit board 4 so as to inhibit molten pre-tin 5 from flowing towards adjacent pads. Subsequently, the heat presser 10 is lifted away from the pre-tin 5 on the circuit board 4 by the motion unit 3, here, the pre-tin on the circuit board 4 is cooled to form the shaped pre-tin 6 having a V-shaped cross section (as shown in Fig.3), as a result, the position of the electrical contact in the pad of the circuit board 4 is precisely controlled, which facilitate the soldering connection.

Further, the heat-press unit 1 may comprise one or more heat pressers 10. In the case that the heat-press unit 1 comprises one heat presser 10, the method comprises the following step: moving the heat presser 10 in the heat-press unit 1 by the motion unit 3 so as to perform the heat-press operation to the pre-tins 5 on the pads of the circuit board 4 one by one, and then shaping the pre-tins 5 on the pads of the circuit board 4 one by one. However, in the case that the heat-press unit 1 comprises a plurality of heat pressers 10, the method comprises the following step: simultaneously performing the heat-press operation to the pre-tins 5 on the pads of the circuit board 4. Regarding to the specific number of the heat presser 10, it may be designed as required.

Further, in case the pre-tin shaping system provided by the present disclosure further comprises the temperature control unit (not shown) configured to control the temperature at which the heat-press operation is performed by the heat-press unit 1, the pre-tin shaping method provided herein further comprises the steps of: by means of the close-loop feedback control, adjusting, by the temperature control unit, the temperature at which the heat-press operation is performed by the heat-press unit. For example, the temperature control unit may heat the heat presser in the heat-press unit to different predetermined temperatures under which the pre-tin is melted according to different compositions of the pre-tin by means of close-loop feedback control.

Additionally, the pre-tin shaping method provided herein further comprises the step of: moving the board holding unit 2 relative to the motion unit 3, as long as the movement accuracy of the relative movement between the board holding unit 2 and the motion unit 3 may be guaranteed.

As can be seen from above, with the pre-tin shaping system and method provided by the present disclosure, the heat-press operation to the pre-tin on the pad of the circuit board that is securely held in the board holding unit is performed by the heat presser so that press the pre-tin on the pad is pressed into a predetermined shape (for example the shaped pre-tin has a V-shaped or U-shaped cross-section), thereby facilitating a soldering connection, performed in a subsequent process, between an electrical contact (not shown) and the pre-tin on the pad of the circuit board. It can be seen that, with the pre-tin shaping system and method provided by the present disclosure, by performing a shaping operation to the pre-tin on the pad of the circuit board, position of an electrical contact on the pad of the circuit board during soldering will be precisely controlled, thereby guaranteeing soldering quality and reducing a risk of dry joint or faulty joint and the like.

The specific embodiments of the present disclosure disclosed herein are intended to describe the principle and functions of the present disclosure exemplarily, but should not be construed as a limitation to the present disclosure. It would be appreciated by those skilled in the art that various changes or modifications may be made in these embodiments without departing from the principles of the disclosure, the scope of which is defined in the appended claims and their equivalents.

## Claims

1. A pre-tin shaping system for shaping a pre-tin (5) on a pad of a circuit board (4), the pre-tin shaping system comprising:
a board holding unit (2) for securely holding the circuit board (4);
a heat-press unit (1) for performing a heat-press operation to the pre-tin (5) on the pad of the circuit board (4) so as to shape the pre-tin (5); and
a motion unit (3) for moving the heat-press unit (1) relative to the board holding unit (2);
wherein the heat-press unit (1) comprises a heat presser (10) for shaping the pre-tin (5) on the pad of the circuit board wherein the heat presser (10) comprises two supporting portions (11) and a heat pressing portion (12) disposed between the two supporting portions (11 **characterized in that** when the heat presser (10) performs the heat-press operation to the pre-tin (5) on the pad of the circuit board (4), the pre-tin (5) is pressed by the heat pressing portion (12) while the supporting portions (11) come into contact with the circuit board (4) at each side of the pad so as to inhibit molten pre-tin (5) from flowing towards adjacent pads.

2. The pre-tin shaping system according to claim 1, wherein,
the heat pressing portion (12) has a U-shaped or V-shaped cross-section.

3. The pre-tin shaping system according to claim 1 or 2, wherein,
the heat pressing portion (12) is made of a material that is not adhesive to the pre-tin (5).

4. The pre-tin shaping system according to claim 3, wherein,
the material that is not adhesive to the pre-tin (5) comprises molybdenum alloy or titanium alloy.

5. The pre-tin shaping system according to claim 1, wherein,
the heat-press unit (1) comprises one or more heat pressers (10).

6. The pre-tin shaping system according to claim 1, wherein,
the board holding unit (2) is moveable relative to the motion unit (3).

7. The pre-tin shaping system according to claim 1, further comprising:
a temperature control unit provided at the heat-press unit (1) and configured to control a temperature at which the heat-press operation is performed by the heat-press unit (1).

8. A method for shaping the pre-tin (5) by the pre-tin shaping system according to claim 1, the method comprising the following steps:
securely holding the circuit board (4) by the board holding unit (2);
moving the heat-press unit (1) relative to the board holding unit (2) by the motion unit (3) so as to align the heat presser (10) of the heat-press unit (1) to the pre-tin (5) on the pad of the circuit board (4); and
performing the heat-press operation to the pre-tin (5) on the pad of the circuit board (4) by the heat-press unit (1) so as to shape the pre-tin (5), wherein the heat presser (10) comprises two supporting portions (11) and a heat pressing portion (12) disposed between the two supporting portions (11),
the method further comprising the following step:
when the heat presser (10) performs the heat-press operation to the pre-tin (5) on the circuit board (4), the pre-tin (5) is pressed by the heat pressing portion (11) while the supporting portions (12) come into contact with the circuit board (4) at each side of the pad so as to inhibit molten pre-tin (5) from flowing towards adjacent pads.

9. The method according to claim 8, further comprising the following step:
moving the board holding unit (2) relative to the motion unit (3).

10. The method according to claim 8, wherein the heat-press unit (1) comprises one or more heat pressers (10),
the method further comprising the following step:
performing the heat-press operation simultaneously by the one or more heat pressers (10).

11. The method according to claim 8, wherein the system further comprises a temperature control unit provided at the heat-press unit (1),
the method further comprising the following step:
adjusting, by the temperature control unit, by means of a close-loop feedback control, the temperature at which the heat-press operation is performed by the heat-press unit (10).

## Patentansprüche

1. Vorverzinnungsformungssystem zum Formen einer Vorverzinnung (5) auf einem Kontaktfleck einer Leiterplatte (4), wobei das Vorverzinnungsformungssystem umfasst:
eine Plattenhalteeinheit (2), um die Leiterplatte (4) zuverlässig zu halten;
eine Warmpresseinheit (1) zum Durchführen eines Warmpressvorgangs an der Vorverzinnung (5) auf dem Kontaktfleck der Leiterplatte (4), um die Vorverzinnung (5) zu formen; und
eine Bewegungseinheit (3) zum Bewegen der Warmpresseinheit (1) relativ zu der Plattenhalteeinheit (2);
wobei die Warmpresseinheit (1) eine Warmpresse (10) zum Formen der Vorverzinnung (5) auf dem Kontaktfleck der Leiterplatte umfasst, wobei die Warmpresse (10) zwei Halteabschnitte (11) und einen Warmpressabschnitt (12) umfasst, der zwischen den zwei Halteabschnitten angeordnet ist,
**dadurch gekennzeichnet, dass**
wenn die Warmpresse (10) den Warmpressvorgang an der Vorverzinnung (5) auf dem Kontaktfleck der Leiterplatte (4) durchführt, die Vorverzinnung (5) von dem Warmpressabschnitt (12) gepresst wird, während die Halteabschnitte (11) mit der Leiterplatte (4) auf jeder Seite des Kontaktflecks in Kontakt kommen, um zu verhindern, dass geschmolzene Vorverzinnung (5) in Richtung der benachbarten Kontaktflecken fließt.

2. Vorverzinnungsformungssystem nach Anspruch 1, wobei
der Warmpressabschnitt (12) einen U-förmigen oder einen V-förmigen Querschnitt aufweist.

3. Vorverzinnungsformungssystem nach Anspruch 1 oder 2, wobei der Warmpressabschnitt (12) aus einem Material besteht, das an der Vorverzinnung (5) nicht haftet.

4. Vorverzinnungsformungssystem nach Anspruch 3, wobei
das Material, das an der Vorverzinnung (5) nicht haftet, eine Molybdänlegierung oder eine Titanlegierung umfasst.

5. Vorverzinnungsformungssystem nach Anspruch 1, wobei
die Warmpresseinheit (1) eine oder mehrere Warmpressen (10) umfasst.

6. Vorverzinnungsformungssystem nach Anspruch 1, wobei
die Plattenhalteeinheit (2) relativ zu der Bewegungseinheit (3) beweglich ist.

7. Vorverzinnungsformungssystem nach Anspruch 1, des Weiteren umfassend:
eine Temperatursteuerungseinheit, die an der Warmpresseinheit (1) angeordnet und dazu konfiguriert ist, eine Temperatur zu steuern, bei welcher der Warmpressvorgang durch die Warmpresseinheit (1) durchgeführt wird.

8. Verfahren zum Formen der Vorverzinnung (5) durch das Vorverzinnungsformungssystem nach Anspruch 1, wobei das Verfahren folgende Schritte umfasst:
sicheres Halten der Leiterplatte (4) durch die Plattenhalteeinheit (2);
Bewegen der Warmpresseinheit (1) relativ zu der Platteneinheit (2) durch die Bewegungseinheit (3), um die Warmpresse (10) der Warmpresseinheit (1) zu der Vorverzinnung (5) auf dem Kontaktfleck der Leiterplatte (4) auszurichten; und
Durchführen des Warmpressvorgangs an der Vorverzinnung (5) auf dem Kontaktfleck der Leiterplatte (4) durch die Warmpresseinheit (1), um die Vorverzinnung (5) zu formen, wobei die Warmpresse (10) zwei Halteabschnitte (11) und einen Warmpressabschnitt (12) umfasst, der zwischen den zwei Halteabschnitten (11) angeordnet ist,
wobei das Verfahren des Weiteren den folgenden Schritt umfasst:
wenn die Warmpresse (10) den Warmpressvorgang an der Vorverzinnung (5) auf der Leiterplatte (4) durchführt, die Vorverzinnung (5) von dem Warmpressabschnitt (11) gepresst wird, während die Halteabschnitte (12) mit der Leiterplatte (4) auf jeder Seite des Kontaktflecks in Kontakt kommen, um zu verhindern, dass geschmolzene Vorverzinnung (5) in Richtung der benachbarten Kontaktflecken fließt.

9. Verfahren nach Anspruch 8, des Weiteren umfassend den folgenden Schritt:
Bewegen der Plattenhalteeinheit (2) relativ zu der Bewegungseinheit (3).

10. Verfahren nach Anspruch 8, wobei die Warmpresseinheit (1) eine oder mehrere Warmpressen (10) umfasst,
wobei das Verfahren des Weiteren den folgenden Schritt umfasst:
Durchführen des Warmpressvorgangs gleichzeitig durch die einen oder mehreren Warmpressen (10).

11. Verfahren nach Anspruch 8, wobei das System des Weiteren eine Temperatursteuerungseinheit umfasst, die an der Warmpresseinheit (1) angeordnet ist,
wobei das Verfahren des Weiteren den folgenden Schritt umfasst:
Anpassen, durch die Temperatursteuerungseinheit, mithilfe einer geschlossenen Rückkopplungsschleife, der Temperatur, bei welcher der Warmpressvorgang durch die Warmpresseinheit (10) durchgeführt wird.

## Revendications

1. Système de façonnage de pré-étamage pour façonner un pré-étamage (5) sur une pastille d'une carte de circuit imprimé (4), le système de façonnage de pré-étamage comprenant :
une unité de maintien de carte (2) pour immobiliser la carte de circuit imprimé (4) ;
une unité de pressage à chaud (1) pour exécuter une opération de pressage à chaud sur le pré-étamage (5) sur la pastille de la carte de circuit imprimé (4) de manière à façonner le pré-étamage (5) ; et
une unité de déplacement (3) pour déplacer l'unité de pressage à chaud (1) par rapport à l'unité de maintien de carte (2) ;
dans lequel l'unité de pressage à chaud (1) comprend un presseur à chaud (10) permettant de façonner le pré-étamage (5) sur la pastille de la carte de circuit imprimé, dans lequel
le presseur à chaud (10) comprend deux parties de support (11) et une partie de pressage à chaud (12) située entre les deux parties de support (11), **caractérisé en ce que**,
lorsque le presseur à chaud (10) exécute l'opération de pressage à chaud sur le pré-étamage (5) sur la pastille de la carte de circuit imprimé (4), le pré-étamage (5) est pressé par la partie de pressage à chaud (12) tandis que les parties de support (11) entrent en contact avec la carte de circuit imprimé (4) de chaque côté de la pastille de manière à empêcher le pré-étamage (5) fondu de s'écouler vers des pastilles adjacentes.

2. Système de façonnage de pré-étamage selon la revendication 1, dans lequel la partie de pressage à chaud (12) a une section transversale en forme de U ou en forme de V.

3. Système de façonnage de pré-étamage selon la revendication 1 ou 2, dans lequel la partie de pressage à chaud (12) est formée d'un matériau qui ne colle pas au pré-étamage (5).

4. Système de façonnage de pré-étamage selon la revendication 3, dans lequel le matériau qui ne colle pas au pré-étamage (5) comprend un alliage du molybdène ou un alliage de titane.

5. Système de façonnage de pré-étamage selon la revendication 1, dans lequel l'unité de pressage à chaud (1) comprend un ou des presseur(s) à chaud (10).

6. Système de façonnage de pré-étamage selon la revendication 1, dans lequel l'unité de maintien de carte (2) est mobile par rapport à l'unité de déplacement (3).

7. Système de façonnage de pré-étamage selon la revendication 1, comprenant, en outre :
une unité de contrôle de température située au niveau de l'unité de pressage à chaud (1) et conçue pour contrôler une température à laquelle l'opération de pressage à chaud est exécutée par l'unité de pressage à chaud (1).

8. Procédé de façonnage du pré-étamage (5) par le système de façonnage de pré-étamage selon la revendication 1, le procédé comprenant les étapes suivantes :
immobilisation de la carte de circuit imprimé (4) au moyen de l'unité de maintien de carte (2) ;
déplacement de l'unité de pressage à chaud (1) par rapport à l'unité de maintien de carte (2) au moyen de l'unité de déplacement (3) de manière à aligner le presseur à chaud (10) de l'unité de pressage à chaud (1) avec le pré-étamage (5) sur la pastille de la carte de circuit imprimé (4) ; et
exécution de l'opération de pressage à chaud sur le pré-étamage (5) sur la pastille de la carte de circuit imprimé (4) par l'unité de pressage à chaud (1) de manière à façonner le pré-étamage (5), dans lequel le presseur à chaud (10) comprend deux parties de support (11) et une partie de pressage à chaud (12) située entre les deux parties de support (11),
le procédé comprenant, en outre, l'étape suivante :
lorsque le presseur à chaud (10) exécute l'opération de pressage à chaud sur le pré-étamage (5) sur la carte de circuit imprimé (4), le pré-étamage (5) est pressé par la partie de pressage à chaud (12) tandis que les parties de support (11) entrent en contact avec la carte de circuit imprimé (4) de chaque côté de la pastille de manière à empêcher le pré-étamage (5) fondu de s'écouler vers des pastilles adjacentes.

9. Procédé selon la revendication 8, comprenant, en outre, l'étape suivante :
déplacement de l'unité de maintien de carte (2) par rapport à l'unité de déplacement (3).

10. Procédé selon la revendication 8, dans lequel l'unité de pressage à chaud (1) comprend un ou des presseur(s) à chaud (10),
le procédé comprenant, en outre, l'étape suivante :
exécution simultanée de l'opération de pressage à chaud au moyen du ou des presseur(s) à chaud (10).

11. Procédé selon la revendication 8, dans lequel le système comprend, en outre, une unité de contrôle de température située au niveau de l'unité de pressage à chaud (1),
le procédé comprenant, en outre, l'étape suivante :
réglage par l'unité de contrôle température, au moyen d'une régulation en boucle fermée, de la température à laquelle l'opération de pressage à chaud est exécutée par l'unité de pressage à chaud (10).
